**Europäisches Patentamt**

**European Patent Office**

**Office européen des brevets**

(19)

(11) **EP 1 176 720 A2**

(12) **EUROPÄISCHE PATENTANMELDUNG**

(43) Veröffentlichungstag:
**30.01.2002 Patentblatt 2002/05**

(51) Int Cl.⁷: **H03K 3/53**

(21) Anmeldenummer: **01116149.4**

(22) Anmeldetag: **04.07.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **27.07.2000 DE 10036519**

(71) Anmelder: **Forschungszentrum Karlsruhe GmbH 76133 Karlsruhe (DE)**

(72) Erfinder:
• **Kupermann, Grigory, Dr.
  76149 Karlsruhe (DE)**
• **Jüngst, Klaus-Peter, Dr.
  76297 Stutensee (DE)**

(54) **Verfahren zur Steuerung der Netzgeräte zum Laden der Energiespeicher eines Leistungsmodulators und Leistungsmodulator zur Durchführung des Verfahrens**

(57) Es wird ein Steuersystem für Leistungsnetzgeräte zur Ladung der Energiespeicher in einem Impulsmodulator, welcher induktive und kapazitive, in Reihe zur Last geschaltete Energiespeicher im einem Impulsmodulator enthält, beschrieben. Das Steuersystem sichert eine wesentliche Erhöhung der Stabilität der Ausgangsspannung des Modulators, darunter auch beim Betrieb mit einer wechselnden, nichtlinearen Last. Es bringt eine Verringerung der Kosten bei der Herstellung und dem Betrieb des Modulators sowie eine Erhöhung der Zuverlässigkeit des Modulators.

**EP 1 176 720 A2**

**Beschreibung**

Die Erfindung betrifft ein Verfahren zur Steuerung eines Leistungsmodulator und einen Leistungsmodulator zur Durchführung des Verfahrens.

Energiespeicher, die die für einen Strompuls benötigte Energie zwischenspeichern und binnen kürzester Zeit an die Last abgeben können, werden zur Erzeugung von Hochleistungspulsen benötigt. Als Energiespeicher werden pulsformende Netzwerke (PFN), sowie große Kapazitäten, Kondensatorbänke, oder Induktivitäten, Spulen bzw. Drosseln, benutzt.

Die elektrische Spannung an der Last wird von der an den Kondensatoren vorhandenen Spannung oder von dem in Induktivitäten fließenden Strom vor dem Pulsanfang definiert. Die Änderung der Spannung an der Last von Puls zu Puls und während des Impulsdaches darf in Modulatoren von Linearbeschleuniger +/- 0,1 - 1% nicht übersteigen.

In einem Modulator mit kapazitivem Speicher, welcher von den Fermi National Accelerator Laboratories entwickelt wurde, wird die Spannung an der Kondensatorbank zu Beginn des Impulses (die Amplitude des Ausgangsimpulses) mit einer Steuereinrichtung durch die Regelung des mittleren Wertes der Ausgangsspannung des Netzgerätes stabilisiert (Konferenzbericht anläßlich des Twenty-First International Power Modulator Symposium 1994 June 27-30, 1994, Costa Mesa, California; H. Pfeffer et al. 3.3: «A Long Pulse Modulator for Reduced Size and Cost» ). Dabei werden die Änderungen/Schwankungen der Spannung am Kondensator zu Beginn des Impulses bei Änderungen der Netzspannung von + 1% bis zu - 5% der Nennspannung erreicht.

In dem in der DE 4440 013 C1 beschriebenen Modulator, der aus folgenden in Reihe geschalteten Einrichtungen:

- einer Einrichtung für einen kapazitiven Energiespeicher, welche parallel geschaltet eine Kondensatorbank, einen Spannungsgeber und ein steuerbares Netzgerät enthält,
- einer Einrichtung für einen induktiven Energiespeicher, welche in Reihe geschaltet einen supraleitenden magnetischen Energiespeicher oder eine "warme" Drossel, einen Stromgeber und ein steuerbares Netzgerät sowie einen die erwähnten in Reihe geschalteten Baueinheiten überbrückenden Leistungsschalter enthält,
- einem zweiten Leistungsschalter und
- einer Last,

besteht, ist eine elektronische Steuereinrichtung angeschlossen, mit der der Strom durch den induktiven Energiespeicher und die Spannung über dem kapazitiven Energiespeicher überwacht und gesteuert werden, so daß zu Beginn des geschlossenen Zustandes des zweiten Leistungskommutators die für die Pulsform entscheidenden Anfangsbedingungen, nämlich der Strom durch den induktiven Energiespeicher und die Spannung über dem kapazitiven Energiespeicher, bestehen.

Aus in der DE 44 40 013 C1 für den Laststrom eingeführten Gleichung folgt, dass sich bei Sicherung der Stabilität von $I_0$ und $U_0$ im Fall eines nichtlinearen oder zeitlich veränderlichen Lastwiderstandes, wie z. B. einem Klystron, die Amplitude und die Spannungsschwankungen des Impulsdaches wesentlich verändern. So hat zum Beispiel eine Änderung des Lastwiderstandes um 15 % bis 20 % ein Änderung der Amplitude der Spannungsschwankungen des Impulsdaches um das mehr als das Zweifache zur Folge. Außerdem, wenn als Leistungskommutator im induktiven Energiespeicher ein Thyristorschalter verwendet wird - was im Vergleich zu einem IGBT- oder IGCT-Schalter die Kosten für Bau und Wartung des Leistungsmodulators deutlich verringert -, kann eine Änderung des Lastwiderstandes zu Störungen im Modulator führen. Das kann deshalb passieren, weil das Zeitintervall, während dessen an die Thyristoren eine Sperrspannung angelegt wird, geringer sein kann als die Freiwerdezeit, Wiederherstellungszeit der elektrischen Festigkeit, der Thyristoren.

Der Erfindung liegt die Aufgabe zugrunde, in einem Leistungsmodulator, welcher mit einer Last, einem Klystron häufig, über einen Leistungsschalter zu einem elektrischen Kreis geschlossen werden kann, geschaltete induktive und kapazitive Energiespeichereinrichtungen enthält, die Steuereinrichtung so zu erweitern und zu verbessern, dass die Stabilität der Ausgangsspannung und Zuverlässigkeit des Leistungsmodulators wesentlich höher sind, und die Kosten für Bau und Betrieb des Leistungsmodulators verringert werden.

Die Aufgabe wird erfindungsgemäß durch ein Verfahren gemäß Anspruch 1 und einem gemäß Anspruch 3 aufgebauten Leistungsmodulator gelöst.

Das Verfahren besteht grundsätzlich aus folgenden Schritten:
Mit einem Spannungsgeber 1-2 wird der Energieinhalt des kapazitiven Speichers erfaßt und ein entsprechendes Signal davon an den Rechner 7 weitergeleitet, der davon abhängig das Netzgerät 1-3 in der Ladephase oder in der Impulspausenzeit steuert und auflädt. Mit einem Stromgeber 2-2 wird der Strom während der Pulszeit durch den Modulator erfaßt und ein entsprechendes Signal davon an den Rechner 7 weitergeleitet. Ein den induktiven Energiespeicher 2-1 überbrückender Spannungsgeber 5 erfaßt durch ein spannungsmäßig analoges Signal die Änderung des Energieinhalts. Das Signal wird in einer angeschlossenen Meßeinrichtung 6 aufbereitet und an den Rechner 7 weitergeleitet. Auch die andern Bauteile des induktiven Kreises könnten zur Signalbildung von dem Spannungsgeber 5 überbrückt sein. Sinnvoll aufgrund einer einfach nutzbaren Signalamplitude wäre das nur noch am Leistungsschalter 2-4.

Die Spannung am kapazitiven Energiespeicher 1-2 und der Strom durch den induktiven Energiespeicher 2-1 werden durch den Rechner 7 über das jeweilige Netzgerät gesteuert und überwacht, bis die maßgebenden Anfangs- oder Startbedingungen erreicht sind. Mit Erreichen dieses Zustands wird der Leistungsschalter 3 zur Führung des Laststromes vom gesperrten in den leitenden Zustand gesteuert und der Leistungsschalter 2-4 im induktiven Kreis in den komplementären, den sperrenden Zustand, um den Lastkreis zu schließen.

Ist der Stromimpuls durch die Last zu Ende, wird der Leistungsschalter 3 im Laststromkreis in den sperrenden Zustand gesteuert und der Leistungsschalter 2-4 in den dazu komplementären, den leitenden. Entsprechend den geforderten Anfangsbedingungen für den nächsten Stromimpul wird zunächst der induktive Energiespeicher 2-1 über das Netzgerät 2-3 geladen. Davon abhängig wird der kapazitive Energiespeicher 1-1 über das Netzgerät 1-3 auf die notwendige Spannung aufgeladen. Das geht folgendermaßen vor sich: Aus dem Signal von der Zeitintervall-Meßeinrichtung 6, das durch den angeschlossenen Spannungsgeber 5 generiert wird, wird im Zeitraum des leitenden Zustandes des Leistungsschalters 3 und während des Intervalls der Stromzunahme im Lastkreis in Abhängigkeit dieser Intervalldauer die geflossenen Ladung unter Berücksichtigung des aktuellen Wertes der Last 4 über den Rechner 7 der Verlauf eines Signals für die Steuerung der Ausgangsspannung des Netzgerätes 1-3 zur Ladung des kapazitiven Energiespeichers 1-1 während der anschließenden Ladephase abgeleitet. Diese an das Netzgerät 1-3 angelegte Steuerspannung stellt über den dadurch gesteuerten Ladevorgang die Spannung am kapazitiven Energiespeicher 1-1 ein, bis die spannungsmäßige Anfangsbedingung für den Impuls eingestellt bzw. erreicht ist.

Im Anspruch 2 ist über eine weitere, an die Last 4 angeschlossene Baukomponente ein zusätzlicher Verfahrensschritt möglich: Über einen weiteren Spannungsgeber 8, der die Last 4 überbrückt, wird ein Signal erzeugt, das in der Vergleichseinrichtung 9 mit einer Referenzspannung von einer Referenzspannungsquelle 10 verglichen wird. Das daraus entstandene Vergleichssignal wird im Rechner 7 zu einem Steuersignal für die Spannungsquelle 2-3 gewandelt, mit dem der notwendige Strom durch den induktiven Energiespeicher, der Spannungsquelle, unmittelbar vor dem Beginn des Stromimpulses durch die Last 4 eingestellt wird.

Der Leistungsmodulator ist Teil eines aus ihm und der Last bestehenden, über einen Schalter öffen- und schließbaren Stromkreises, der grundsätzlich folgendermaßen aufgebaut ist: Er besteht aus einem kapazitiven Energiespeicher 1-1 in Form einer Kondensatorbank, die an ein steuerbares Netzgerät 1-3 angeschlossen ist. Zur Erfassung des elektrischen Energieinhalts überbrückt den Energiespeicher 1-3 ein Spannungsgeber 1-2.

Der induktiver Energiespeicher 2-1 in Form mindestens einer Spule ist an den kapazitiven Energiespeicher 1-1 angeschlossen. Eine steuerbare Spannungsquelle 2-3 mit einem Stromgeber 2-2 in Reihe schließt daran an und liegt mit dem andern Ende an der Last 4. Dieser induktive Zweig wird vom Leistungsschalter 2-4 überbrückt. Der Leistungsschalter 3 liegt auf dem Weg vom kapazitiven Energiespeichers 1-1 zur Last 4. Die Last 4 schließt den Lastkreis. Die beiden Leistungsschalter werden hinsichtlich ihres Zustands komplementär betrieben.

Der Spannungsgeber 5, der entweder den Leistungsschalter 2-4 oder den induktiven Energiespeicher 2-1 überbrückt, ist an die Meßeinrichtung 6 angeschlossen. Der Rechner 7, der die Einrichtungen 1 und 2 verknüpft, überwacht und steuert den Leistungsmodulator mit seinen kapazitiven und induktiven Energiespeichern 1-1 und 2-1. Für Beschleunigeranlagen häufig verwendet, besteht die Last 4 aus einem Pulstransformators (4-1) und einem Klystron 4-2 auf seiner Sekundärseite als die eigentliche Last.

In den Ansprüchen 4 und 5 ist der induktive Energiespeicher spezifiziert, im ersteren als normal leitende Spule, im folgenden als supraleitende Spule, dem sog. SMES.

In Anspruch 6 ist die Meßbeschaltung der Last beschrieben, die eine verfeinerte Steuerung des Leistungsmodulators ermöglicht. Das ist ein Spannungsgeber 8, der die Last überbrückt. Er und eine Referenzspannungsquelle sind an einen Vergleicher angeschlossen, der wiederum an den die Anlage steuernden Rechner, z.B. einen Mikroprozessor (Anspruch 8), angeschlossen ist.

Die verschiedenen möglichen Einbauorte des Spannungsgebers 5 im induktiven Kreis sind in den Ansprüchen 7, Leistungsschalter 2-4, und 8 , induktiver Energiespeicher 2-1, beschrieben. Die andern Bauteile im induktiven Kreis sind ohne zusätzlichen Signalverstärkeraufwand nicht so brauchbar als Signalgeber anzuzapfen.

Dank der Regulierung der Ausgangsspannung des Netzgerätes zur Ladung des kapazitiven Energiespeichers in Abhängigkeit von dem Zeitintervall, in dem der Strom im induktiven Energiespeicher während des Impulses ansteigt, wird die Spannung über dem kapazitiven Energiespeicher nicht nur unter Berücksichtigung des Stromes durch den induktiven Energiespeicher eingestellt, sondern auch unter Berücksichtigung des aktuellen Wertes des Lastwiderstandes des Leistungsmodulators. Das ermöglicht, die Energie zu verringern, die in den Energiespeichern gespeichert werden muß und außerdem die Spannungsschwankungen des Impulsdaches der Ausgangimpulse des Leistungsmodulators zu verringern. Damit können die Kosten für die Herstellung und den Betrieb des Modulators verringert werden. Außerdem wird dadurch die Länge des Zeitintervalls kontrolliert, während dessen nach dem Sperren des Thyristorschalters des induktiven Energiespeichers an die Anode des Kommutators eine negative Spannung im Verhältnis zur Kathode ansteht. Dadurch wird gesichert, dass dieses Zeitintervall nicht kürzer ist als die Freiwerdezeit des Thyristorschalters, wodurch die Zuverlässigkeit des Leistungsmodulators erhöht wird.

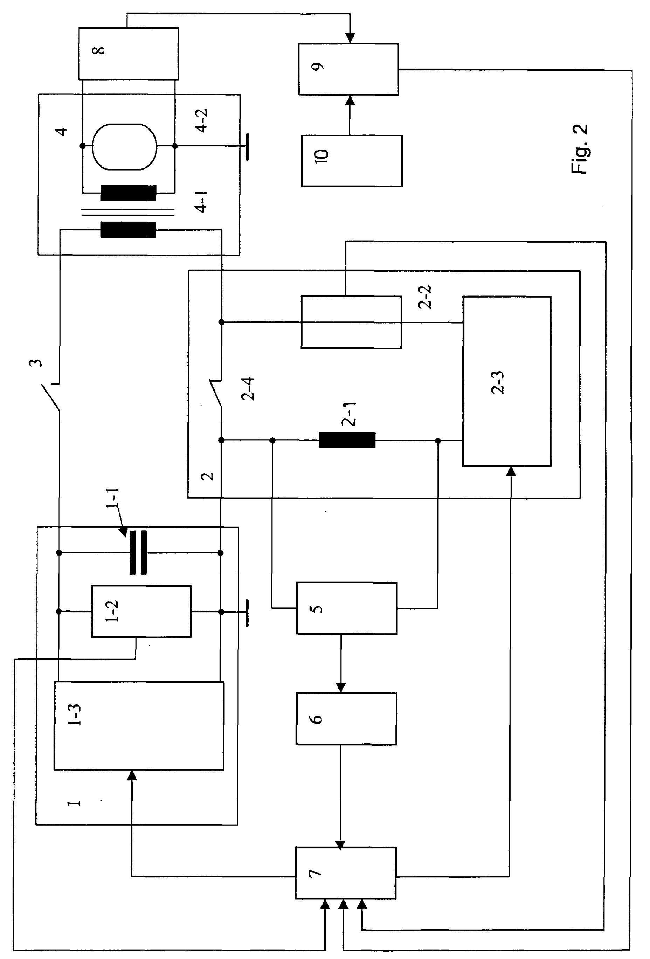

Zur Erhöhung der Stabilität der Amplitude der Ausgangsimpulse des Modulators wird die Steuereinrichtung durch den Rückkopplungskreis zur Ausgangsspannung des Impulsmodulators ergänzt (siehe Ansprüche 2 und 6 sowie oben als auch unten Fig. 2). Wie oben schon gefaßt, wird so die Ausgangsspannung des Impulsmodulators zu Beginn des Impulsdaches mit der Referenzspannung verglichen und der Sollwert der Ausgangsspannung des Netzgerätes 2-3 so eingestellt, dass die Abweichung der Ausgangsspannung des Impulsmodulators von dem Wert, welcher durch die Referenzspannung bestimmt wird, minimiert wird.

Die Erfindung wird anhand der Zeichnung u.a. über das Ausführungsbeispiel im folgenden näher erläutert.

Es zeigen:

Figur 1. Das Schaltprinzip des Leistungsmodulators mit der Steuereinrichtung,

Figur 2. Beispiele für die Ausführung des Leistungsmodulators mit der Steuereinrichtung und mit der negativen Rückkopplung von der Ausgangsspannung des Leistungsmodulators,

Figur 3. Den zeitlichen Verlauf der Ausgangsspannung des Leistungsmodulators bei Nennlastwiderstand,

Figur 4. die zeitlichen Verläufe der Ausgangsspannung des Leistungsmodulators und der Spannung am induktiven Energiespeicher bei 1,15-fachem Nennlastwiderstand im Falle des Standes der Technik,

Figur 5. die zeitlichen Verläufe der Ausgangsspannung des Leistungsmodulators und der Spannung am induktiven Energiespeicher bei 1,15-fachem Nennlastwiderstand in dem Leistungsmodulator gemäß der Erfindung,

Figur 6. die zeitlichen Verläufe der Ausgangsspannung des Leistungsmodulators und der Spannung am induktiven Energiespeicher bei ca. zweifachem Nennlastwiderstand im Falle des Standes der Technik,

Figur 7. den zeitlichen Verlauf der Ausgangsspannung am Leistungsmodulator bei ca. zweifachem Nennlastwiderstand in dem Leistungsmodulator gemäß der Erfindung.

Die Stromquelle 1-3 zum Laden des Kondensators 1-1 ist ein steuerbares Netzgerät mit dem die vorgesehene Spannung am Kondensator 1-1 aufgebaut wird. Der Kondensator 1-1 ist der Hochspannungskondensator zum Formieren des quasirechteckigen Impulses auf die Last 4. Die Spannung am Kondensator 1-1 wird mit dem Spannungsgeber 1-2 kontrolliert. Die Spannungsquelle 2-3 zum Laden des supraleitenden magnetischen Energiespeichers 2-1, kurz SMES, ist ein steuerbares Netzgerät, mit dem der vorgesehene Strom im SMES 2-1 aufgebaut wird. Der Strom im SMES 2-1 wird mit dem Stromgeber 2-2 kontrolliert.

Der Schalter 2-4 besteht aus in Reihe geschalteten Thyristoren. Der Schalter 3 besteht aus hintereinander geschalteten IGCTs (Integrated Gate Commutated Thyristor) oder aus in Reihe geschalteten IGBTs (isolated gate bipolar transistor).

Die Last 4 ist hier ein Klystron 4-2 mit rein ohmschem Charakter, das an der Sekundärseite des an den Modulator geschalteten Pulstransformators angeschlossen ist.

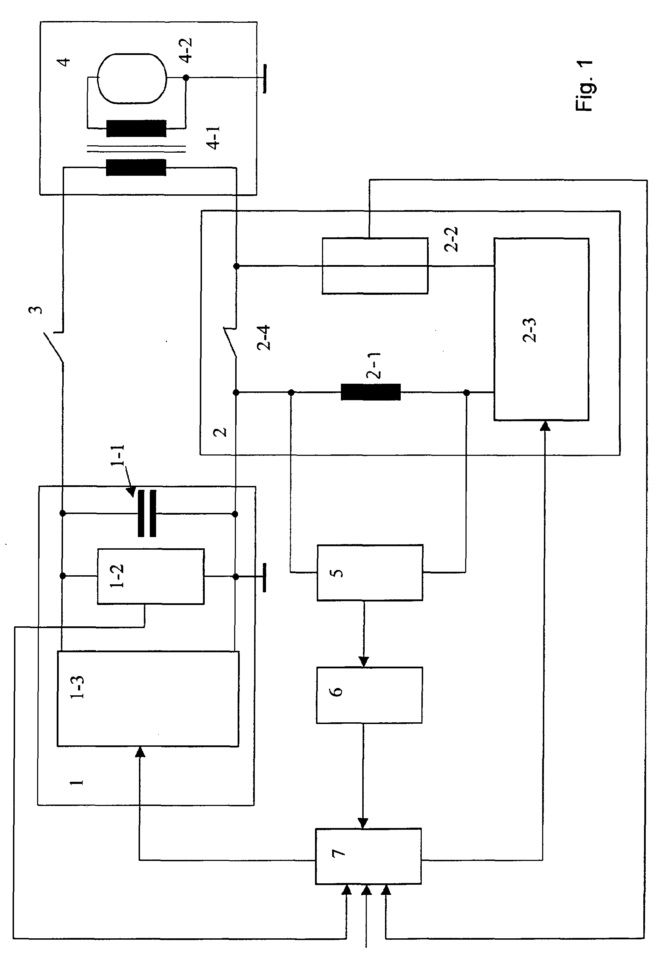

Die Ausgangsspannung des Leistungsimpulsmodulators wird, wie in Figur 1 dargestellt, für das Klystron 4-2 über den Pulstransformator 4-1 hoch transformiert.

Die Spannung am SMES 2-1 wird mit dem Spannungsgeber 5 kontrolliert. Die Meßeinrichtung 6 ist z.B. ein gesteuerter Impulszähler, welcher im Zeitraum zwischen Ein- und Ausschalten des zweiten Leistungsschalters 3 das Zeitintervall kontrolliert, in dem die Spannung über dem induktiven Energiespeicher 2-1 eine Polarität hat, bei der der Strom durch den induktiven Energiespeicher 2-1 ansteigt.

Der Ausgang der Zeitintervall-Meßeinrichtung 6 ist an den Rechner 7 angeschlossen, welcher das gemessene Zeitintervall in ein Signal für die Steuerung der Ausgangsspannung der Netzgeräte 1-3 zur Ladung der kapazitiven Energiespeicher 1-1 umwandelt.

Zur Erhöhung der Stabilität der Amplitude der Ausgangsimpulse des Modulators wird das Signal vom Geber 8 der Ausgangsspannung des Modulators in der Vergleichseinrichtung 9 mit der Referenzspannungsquelle 10 verglichen. Das Ausgangssignal der Vergleichseinrichtung wird an den Eingang des Rechners 7 gelegt und darin in ein Steuersignal für die Spannunsquelle 2-3 umgewandelt, mit dem der vorgegebenen Wert des Stromes in dem SMES 2-1 vor Beginn des Impulses gesichert wird.

Übrige, gängige Dinge wie weitere Meßeinrichtungen, Schutzbeschaltungen und eine daran gekoppelte Steuerelektronik, sind der Übersicht halber und wegen bekannter Technik in den Figuren 1 und 2 nicht eingezeichnet.

Der Modulator ist, wie oben erwähnt, ein System mit zwei passiven Energiespeichern, und zwar dem Kondensator 1-1 und dem SMES 2-1, und funktioniert folgendermaßen:

Als weitere Energiequelle während des Betriebs kommen die steuerbare Stromquelle 1-3 und die steuerbare Spannungsquelle 2-3 hinzu, deren Beitrag während der Pulsdauer allerdings vernachlässigt werden kann, d.h. mit anderen Worten, die Rückwirkung ins Netz während des Pulses ist unproblematisch. Während der Pulspause werden der Kondensator 1-1 über die Stromquelle 1-3 auf die vorgesehene Spannung und der SMES 2-1 über die Spannungsquelle 2-3 und den Schalter 2-4 auf den vorgesehenen Strom aufgeladen. Dabei wird der Schalter 3 gesperrt. Damit sind die vorgegebenen Anfangsbedingungen für den Strom im SMES 2-1 und die Spannung am Kondensator 1-1 eingestellt und der Modulator kann betrieben werden, d.h. die beiden Schalter 2-4 und 3 können synchron in ihre komplementären Zustände gebracht werden.

Ist der Schalter 3 im leitendem Zustand, dann gilt unter Vernachlässigung der Verluste in dem Entladungskreis des Speichers, der Beiträge der Stromquelle 1-3 und der Spannungsquelle 2-3 sowie der parasitären Parameter des Pulstransformators für die Spannung und für den Strom am Eingang des Pulstransformators 4-1:

$$u(t) = U_{SMES}(t) + u_c(t)$$

$$i(t) = e^{-at} * [I_0 * (\cos(bt) + (a/b)*\sin(bt)) -$$

$$U_0/L*1/b*\sin(bt)] \qquad (1)$$

Dabei ist:

$$a = R/2L$$

die Last dividiert durch die doppelte Energiespeicherinduktivität und

$$b^2 = 1/LC - a^2,$$

mit C als der Kondensatorkapazität. Dabei ist die Spannung an der Sekundärwicklung des Pulstransformators praktisch gleich der Spannung am Klystron. Die Gleichung für i(t) beschreibt somit das transiente Entladen der Energiespeicher C und L während der Impulsdauer bei normalem Betrieb.

Im Durchführungsbeispiel sind die Bauteile des Pulsmodulators, wie folgt, dimensioniert worden:

| Kondensatorkapazität | C = 300 μF, |
|---|---|
| Induktivität des SMES | L = 0,07 H, |
| Klystron | R = 8 - 17,6 Ω, |
| Strom | $I_{SMES}$ = 125 - 1250 A, |
| Kondensatorspannung | $U_C$ = 1,33 - 13,3 kV. |

Die Parameter der Widerstände, der Induktivität und der Kapazität sowie die Werte des Stromes und Spannung sind für die Primärwicklung angegeben.

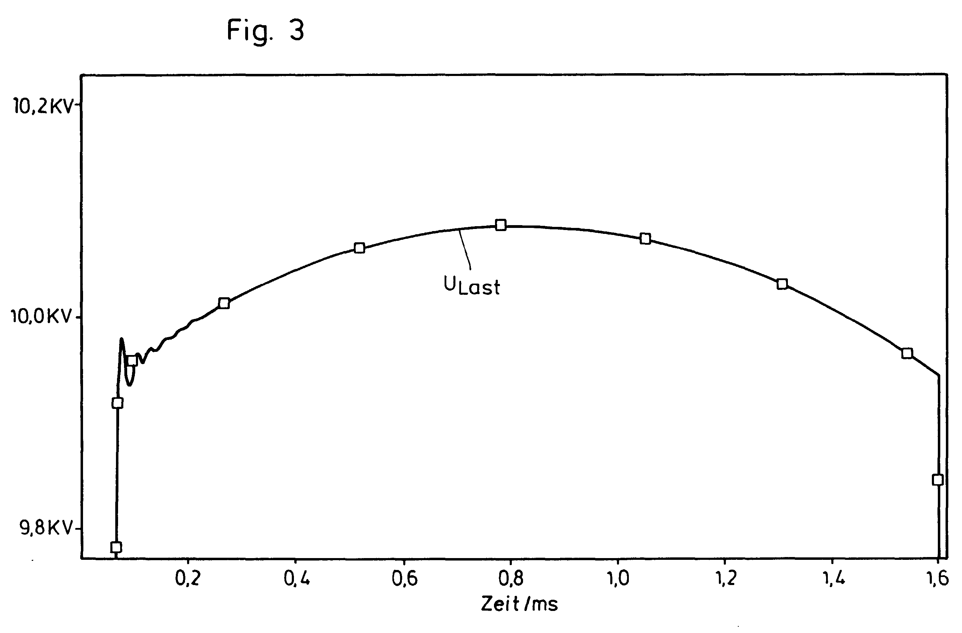

In Fig. 3 ist die Kurve der Ausgangsspannung des Impulsmodulators bei Nennwert des Lastwiderstandes des Modulators dargestellt. Die Anfangswerte des Stromes durch den induktiven Energiespeicher 2-1 und der Spannung über dem kapazitiven Energiespeicher 1-1 wurden so ausgewählt, dass in dem Zeitintervall, welches dem Dach des Ausgangsimpulses des Modulators entspricht, die Abweichungen der Kurve der Ausgangsspannung des Modulators von einer Geraden minimal gehalten werden.

Wie aus der Beziehung (1) und Fig. 3 ersichtlich ist, besitzt diese Funktion i(t) nur ein Maximum. Entsprechend der Tschebyscheff-Approximation ist ein optimaler Ersatz der Funktion durch eine Gerade erreicht, wenn:

1. das Maximum sich innerhalb des Zeitintervalls der Impulsdauer befindet und
2. die Werte der Funktion zu Beginn und am Ende des Zeitintervalls, der Impulsdauer, gleich sind.

Damit erfüllt die Kurve der Ausgangsspannung des Modulators in Fig. 3 in dem Zeitintervall, welches dem Dach des Ausgangsimpulses entspricht, das Kriterium der Tschebyscheff- Approximation. Der Strom, und damit entsprechend der Laststrom durch den induktiven Energiespeicher, wächst vom Beginn des erwähnten Zeitintervalls bis zum Moment, welcher dem maximalen Laststrom entspricht, d.h. im Moment t = 817 μs (siehe Fig. 3) erreicht die Spannung über der Last ihren Maximalwert und die Spannung über dem induktiven Energiespeicher wechselt ihr Vorzeichen.

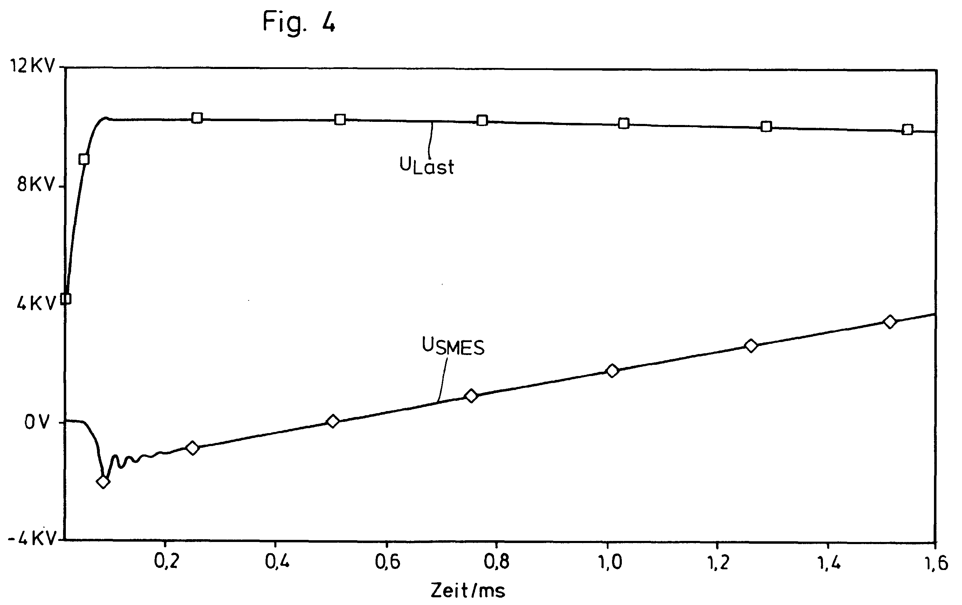

In Fig. 4 sind die Kurven der Ausgangsspannung des Impulsmodulators und der Spannung über dem induktiven Energiespeicher 2-1 bei 1,15-fachem Nennwert des Lastwiderstandes des Modulators für den Fall dargestellt, wenn die Anfangsbedingungen in den Energiespeichern so ausgewählt wird, wie in dem in der DE 44 40 013 C1 beschriebenen Beispiel aus der Bedingung einer linearen Last, d.h. proportional verringert zum Erhalt derselben Ausgangsspannung des Modulators. Wie aus Fig. 4 ersichtlich ist, haben sich die Spannungsschwankungen des Impulsdaches um das Zweifache erhöht, und die Spannung über dem induktiven Energiespeicher wechselt ihr Vorzeichen bei 500 μs nach Beginn des Impulses.

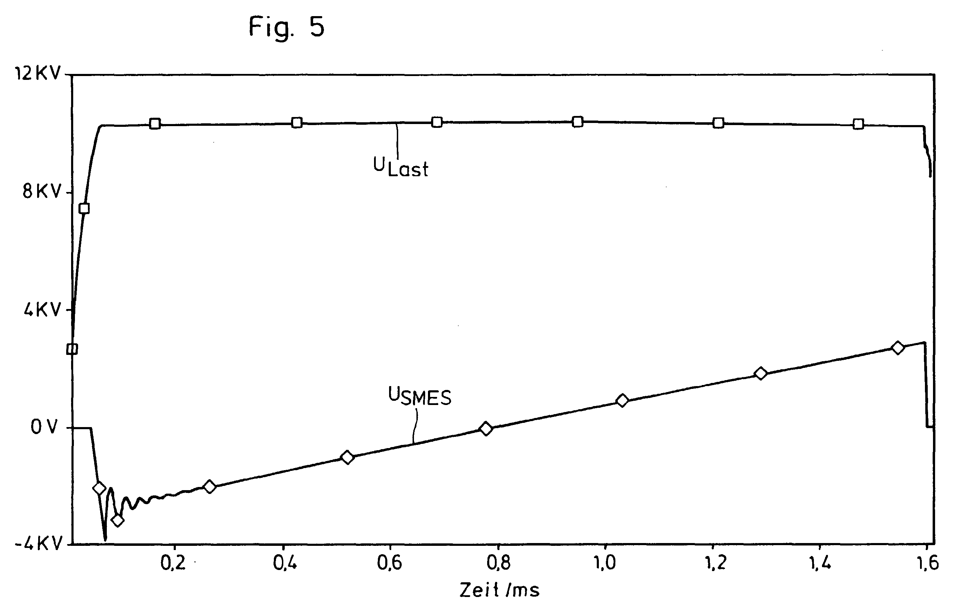

In Fig. 5 sind die Kurven der Ausgangsspannung des Impulsmodulators und der Spannung über dem induktiven Energiespeicher 2-1 bei 1,15-fachem Nennwert des Lastwiderstandes des Modulators für den Fall dargestellt, dass bei demselben Strom durch den induktiven Energiespeicher wie im Beispiel der Fig. 4 die Spannung über dem kapazitiven Energiespeicher vor Beginn des Impulses so eingestellt wird, dass der Zeitpunkt des Durchgangs der Spannung über dem induktiven Energiespeicher durch Null ungefähr dem Fall entspricht, welcher in Fig. 3 dargestellt ist, d.h. 792 μs nach Beginn des Impulses.

Wie weiter aus Fig. 5 ersichtlich, entspricht die Kurve der Ausgangsspannung des Modulators wieder dem Tscherbyschew-Kriterium und die Spannungsschwankungen des Impulsdaches betragen ungefähr +/- 0,7 %. Damit wird die optimale Form der Ausgangsspannung des Modulators gewährleistet, wenn der Rechner 7 den Sollwert für das Netzgerät 1-3 so einstellt, dass der Zeitpunkt, wenn die Spannung über dem induktiven Energiespeicher das Vorzeichen wechselt, 800 µs +/- 50 us nach Beginn des Impulses liegt. Hier wird darauf hingewiesen, dass die Polarität der Spannung über dem induktiven Energiespeicher, bei der der Strom durch den Energiespeicher anwächst, einer negativen Spannung an der Anode im Verhältnis zur Kathode des Thyristorschalters 2-4 entspricht. Damit wird bei einer optimalem Pulsform des Impulsmodulators nach dem Sperren des Thyristorschalters 2-4 an den Schalter für einen Zeitraum von 800 +/- 50 µs eine Rückspannung angelegt.

Da die Freiwerdezeit eines Thyristors gewöhnlich nicht größer ist als 300 µs wird bei Erfüllung der Bedingung gleichzeitig ein sicherer Betrieb der Thyristorschalters 2-4 garantiert. Wenn die Rückspannung an den Thyristor für einen kürzeren Zeitraum angelegt wird als die Freiwerdezeit, wird der Thyristor leitend, ohne daß ein Signal an seiner Steuerelektrode anliegt. Ein solches kann den Thyristor zerstören.

Wie bekannt, wird der statische Widerstand eines Klystrons in Abhängigkeit von seiner Kollektorsspannung folgendermaßen bestimmt:

$$R_{Kl} = U_{Kl}^{-0,5}/p,$$

p ist die Perveanz eines Klystrons.

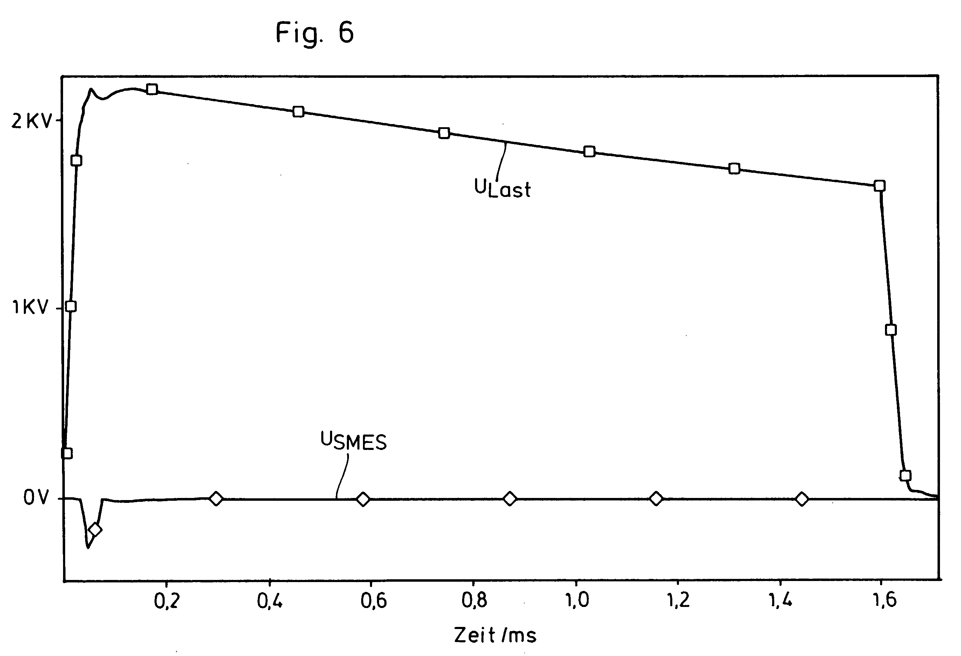

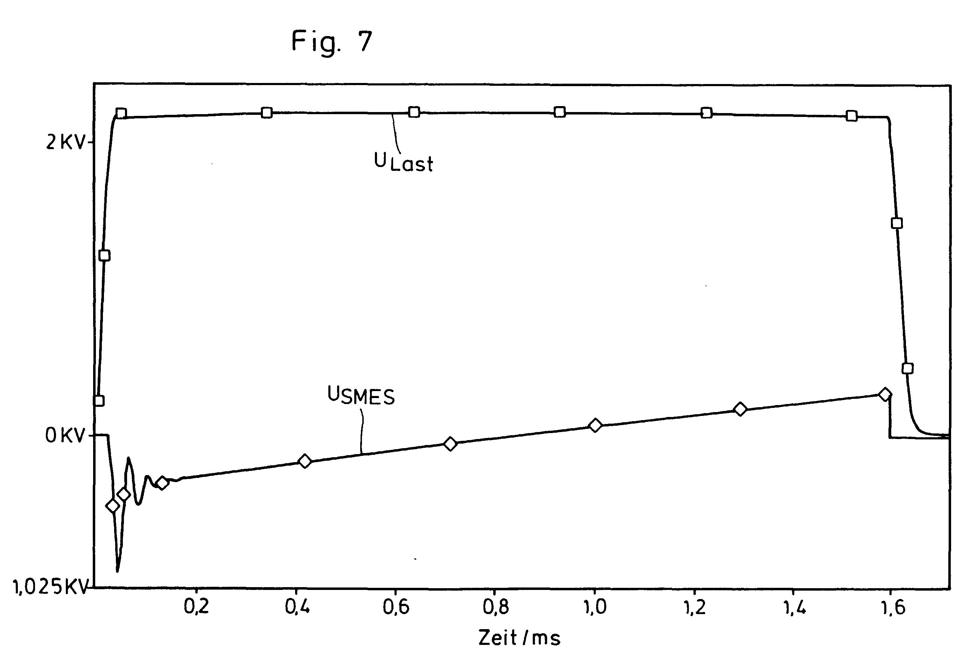

Im Fall des Ansteigens der Spannung am Klystron ab ca. 15% der Nominalspannung, übersteigt der Lastwiderstand des Modulators das Zweifache des Nennwertes. Dieser Fall ist in Fig. 6 und 7 dargestellt:

Fig. 6 betrifft den Fall, dass die Spannung über dem kapazitiven Energiespeicher vor Beginn des Impulses ohne Berücksichtigung des Lastwiderstandes des Modulators eingestellt wird. Die Zeitspanne des Anliegens einer negativen Spannung an der Anode des Thyristorschalters 2-4 beträgt weniger als die Freiwerdezeit des Thyristors.
Fig. 7 zeigt die Kurven des Laststromes des Modulators und der Spannung über dem induktiven Energiespeicher, über dem Thyristorschalter 2-4, praktisch bei demselben Lastwiderstand wie in Fig. 6. Allerdings wurde in diesem Fall die Spannung über dem kapazitiven Energiespeicher so eingestellt, daß die Spannung über dem induktiven Energiespeicher, dem Thyristorschalter 2-4, das Vorzeichen ungefähr nach 800 µs nach Beginn des Impulses wechselt. Damit wird ein zuverlässiger Betrieb des Thyristorschalters gesichert.

Bezugszeichenliste

| | |
|---|---|
| 1 | kapazitive Einrichtung |
| 1-1 | kapazitiver Energiespeicher, Kondensatorbank |
| 1-2 | Spannungsgeber |
| 1-3 | Netzgerät |
| 2 | induktive Einrichtung |
| 2-1 | induktiver Energiespeicher, Spulenbatterie |
| 2-2 | Stromgeber |
| 2-3 | Netzgerät |
| 2-4 | Leistungsschalter |
| 3 | Leistungsschalter |
| 4 | Last |
| 4-1 | Pulstransformator |
| 4-2 | Klystron, eigentliche Last |
| 5 | Spannungsgeber |
| 6 | Zeitintervall- Meßeinrichtung |
| 7 | Rechner, Mikroprozessor |
| 8 | Spannungsgeber |
| 9 | Vergleicher |
| 10 | Referenzspannungsquelle |

Patentansprüche

1. Verfahren zur Steuerung der Netzgeräte zum Laden der Energiespeicher eines Leistungsmodulators, wobei
der Leistungsmodulator aus folgenden in Reihe geschalteten Einrichtungen (1) bis (3), die mit einer Last (4) zu einem Kreis geschlossen werden, besteht:

- einem kapazitiven Energiespeicher (1-1) in Form einer Kondensatorbank aus mindestens einem Kondensator mit einem den Energiespeicher (1-1) überbrückenden Spannungsgeber (1-2) und
einem ebenfalls den Energiespeicher (1-1) überbrückenden steuerbaren Netzgerät (1-3),
- einem induktiven Energiespeicher (2-1) in Form mindestens einer Spule mit
einem Stromgeber (2-2),
einem steuerbaren Netzgerät (2-3) und einem den Ein- und Ausgang der Reihenschaltung aus dem magnetischen Energiespeicher, dem Netzgerät (2-3) und dem Stromgeber (2-2) überbrückenden Schalter (2-4), dem induktiven Kreis,
- einem Leistungsschalter (3) zwischen dem Eingang des kapazitiven Energiespeichers (1-1) und dem Eingang der Last (4),
einem Spannungsgeber (5), der aus dem induktiven Kreis entweder den Energiespeicher (2-1) oder den Leistungsschalter (2-4) überbrückt, mit

einer an ihm ankoppelnden Zeitintervall-Meßeinrichtung (6) und

einem Rechner (7), der die Einrichtungen (1) und (2) verknüpft, überwacht und steuert, und bestehend aus den Schritten:

- mit dem Spannungsgeber (1-2) wird der Energieinhalt des kapazitiven Speichers erfaßt und ein entsprechendes Signal davon an den Rechner (7) weitergeleitet, der davon abhängig das Netzgerät (1-3) steuert,

- mit dem Stromgeber (2-2) wird der Strom durch den Modulator erfaßt und ein entsprechendes Signal davon an den Rechner (7) weitergeleitet,

- mit dem den induktiven Energiespeicher (2-1) überbrückenden Spannungsgeber (5) wird die Änderung des Energieinhalts erfaßt und über die Meßeinrichtung (6) an den Rechner weitergeleitet,

- mit dem Rechner werden die Spannung am kapazitiven Energiespeicher (1-2) und der Strom durch den induktiven Energiespeicher (2-1) gesteuert und überwacht, bis die für die vorgesehene Pulsform des Stromes durch die Last entscheidenden Anfangsbedingungen erreicht sind und dann der Leistungsschalter (3) zur Führung des Laststromes vom geöffneten in den leitenden Zustand gesteuert wird,

- das Signal von dem Spannungsgeber (5) über die Zeitintervall-Meßeinrichtung (6) im Zeitraum des leitenden Zustandes des Leistungsschalters (3), dem geschlossenen Lastkreis, und während des Intervalls der Stromzunahme im Lastkreis in Abhängigkeit dieser Intervalldauer über den Rechner (7) der Verlauf eines Signals für die Steuerung der Ausgangsspannung des Netzgerätes (1-3) zur Ladung des kapazitiven Energiespeichers (1-1) während der anschließenden Ladephase abgeleitet und dann an das Netzgerät (1-3) angelegt wird.

**2.** Verfahren nach Anspruch 1,
**dadurch gekennzeichnet, daß**
über einen weiteren Spannungsgeber (8), der die Last (4) überbrückt, ein Signal erzeugt wird, das in einer Vergleichseinrichtung (9) mit einer Referenzspannung von einer Referenzspannungsquelle (10) verglichen wird, und das daraus entstandene Vergleichssignal im Rechner (7) ein Steuersignal für die Spannungsquelle (2-3) generiert, mit dem der notwendige Strom im induktiven Kreis unmittelbar vor dem Beginn des Stromimpulses durch die Last (4) eingestellt wird.

**3.** Leistungsmodulator, mit einer Last (4) zu einem Kreis geschlossen, wobei der Leistungsmodulator aus folgenden in Reihe geschalteten Einrichtungen (1) bis (3), besteht:

- einem kapazitiven Energiespeicher (1-1) in Form einer Kondensatorbank aus mindestens einem Kondensator mit einem den Energiespeicher (1-1) überbrückenden Spannungsgeber (1-2) und einem ebenfalls den Energiespeicher (1-1) überbrückenden steuerbaren Netzgerät (1-3),

- einem induktiven Energiespeicher (2-1) in Form mindestens einer Spule mit einem Stromgeber (2-2), einem steuerbaren Netzgerät (2-3) und einem den Ein- und Ausgang der Reihenschaltung aus dem magnetischen Energiespeicher, dem Netzgerät (2-3) und dem Stromgeber (2-2) überbrückenden Schalter (2-4),

- einem Leistungsschalter (3) zwischen dem Eingang des kapazitiven Energiespeichers (1-1) und dem Eingang zur Last (4),

- einem Spannungsgeber (5), der entweder den Energiespeicher (2-1) oder den Leistungsschalter (2-4) überbrückt, mit einer an ihm ankoppelnden Meßeinrichtung (6) und

- einem Rechner (7), der die Einrichtungen (1) und (2) verknüpft, überwacht und steuert.

**4.** Modulator nach Anspruch 3,
**dadurch gekennzeichnet, dass**
der induktive Energiespeicher (2-1) eine normal leitende Spulenbatterie ist.

**5.** Modulator nach Anspruch 3,
**dadurch gekennzeichnet, dass**
der induktive Energiespeicher (2 - 1) eine supraleitende Spule, ein sogenannter supraleitender magnetischer Energiespeicher, kurz SMES, ist.

**6.** Modulator nach den Ansprüchen 4 und 5,
**dadurch gekennzeichnet, dass**
parallel zur Last, den Eingang oder den Ausgang des Impulstransformators (4-1) überbrückend, ein weiterer Spannungsgeber (8) liegt, dessen Ausgang und eine Referenzspannungsquelle (10) je an einen der Eingänge eines Vergleichers (9) angeschlossen sind und der Ausgang des Vergleichers (9) an den Rechner (7) angeschlossen ist.

**7.** Modulator nach einem der Ansprüche 4 bis 6,
**dadurch gekennzeichnet, dass**
der Spannungsgeber (5) den induktiven Energiespeicher (2-1) überbrückt.

**8.** Modulator nach einem der Ansprüche 4 bis 6,
**dadurch gekennzeichnet, dass**
der Spannungsgeber (5) den Leistungsschalter (2-4) überbrückt.

**9.** Modulator nach den Ansprüchen 7 bis 8,

**dadurch gekennzeichnet, dass**
der Rechner (7) ein Mikroprozessor ist,

Fig. 1

EP 1 176 720 A2

Fig. 2

Fig. 3

$U_{Last}$

Zeit /ms

10,2KV

10,0KV

9,8KV

0,2  0,4  0,6  0,8  1,0  1,2  1,4  1,6

Fig. 4

Fig. 5

Fig. 6

Fig. 7

EP 1 176 720 A2